Europäisches Patentamt

European Patent Office

Office européen des brevets

(19)

(11) EP 1 359 672 A1

(12) EUROPEAN PATENT APPLICATION

(43) Date of publication:
05.11.2003 Bulletin 2003/45

(51) Int Cl.$^7$: H03M 13/29, H03M 13/27

(21) Application number: 02009987.5

(22) Date of filing: 03.05.2002

(84) Designated Contracting States:
AT BE CH CY DE DK ES FI FR GB GR IE IT LI LU
MC NL PT SE TR
Designated Extension States:
AL LT LV MK RO SI

(71) Applicant: SIEMENS AKTIENGESELLSCHAFT
80333 München (DE)

(72) Inventors:
• Calabro, Stefano, Dr.
81375 München (DE)
• Färbert, Andreas, Dr.
81825 München (DE)
• Spinnler, Bernhard, Dr.
81379 München (DE)
• Stojanovic, Nebojsa, Dr.
80469 München (DE)

(54) **Method for improving the performance of concatenated codes**

(57) The method implies the steps of generating check bits (c) from information bits (a), which are represented by an information matrix, by an outer code, shifting cyclically the information bits (a) and the check bits (c) to obtain an interleaved code matrix, and than coding the bits of the interleaved code matrix by an inner code, where at least the outer code or the inner code is a product code.

Figure1:

**Description**

The present invention relates to a method for improving the performance of concatenated codes.

The capacity of optical transmission systems has rapidly increased in the last several years. The ability to upgrade a low bitrate system to a higher bitrate system by improving the optical components and compensating the limiting physical effects was the key for achieving system evolution.

The introduction of error control coding (ECC) was a very efficient tool that successfully improved the performance and reliability of digital data transmission. Adding redundancy check bits to the information bits and advanced decoding provides the possibility of increasing the transmission distance and further makes the system more robust to adverse conditions impairing transmission performance such as temperature variations and acoustic vibrations. Because of complexity reasons hard decoding is preferred to soft decoding. Codes like Bose-Chaudhuri-Hocquenghem codes (BCH) or extended BCH codes, which can be implemented easily, are preferred. To improve coding gain concatenated codes are used. But this group of codes is very sensitive when special error patterns are received. Those error patterns cannot be corrected and thus lead to an increase of the bit error rate (error flaring). This will be explained later in detail.

The basics of product coding are explained in "Prüfbare und korrigierbare Codes" W. Wesley Peterson, Oldenburg Verlag 1967, Seiten 117- 123.

This invention refers to a method for improving the performance of concatenated codes and for the reduction of the error flaring.

The present invention provides a method for improving the bit error rate (BER) and therefore the coding gain according to claim 1 . This is achieved by applying an outer encoding procedure, then interleaving the information bits and at least a group of check bits and finally applying an inner encoding procedure, whereby at least one of the codes is a product code.

The interleaver should be realizable with low design complexity and memory requirement. In order to achieve this, the first column of a two dimensional product code remains unchanged while the elements (bits) of the following columns are cyclically shifted by one, two, three etc. positions, so that the elements of the first row are translated into diagonal elements by the interleaver.

Applying the described interleaving procedure both on columns and rows of a two dimensional product code breaks the error bursts in rows and in columns and offers a possibility to further improve the coding gain.

The above and further characteristics and advantages of the present invention will become more apparent with reference to the following description of certain embodiments of the present invention, given by way of examples only, along with the accompanying drawings.

Figure 1      schematic of a concatenated coding system;

Figure 2      schematic of a two-dimensional product code;

Figure 3      permanent error-pattern;

Figure 4      a two-dimensional code matrix;

Figure 5      exemplary elements of a code matrix;

Figure 6      exemplary elements of an interleaved code matrix;

Figure 7      a final code matrix;

Figure 8      an iterative decoding scheme;

Figure 9      error probability of an enhanced product code;

Figure 10      schematic of the resulting matrix after two dimensional interleaving.

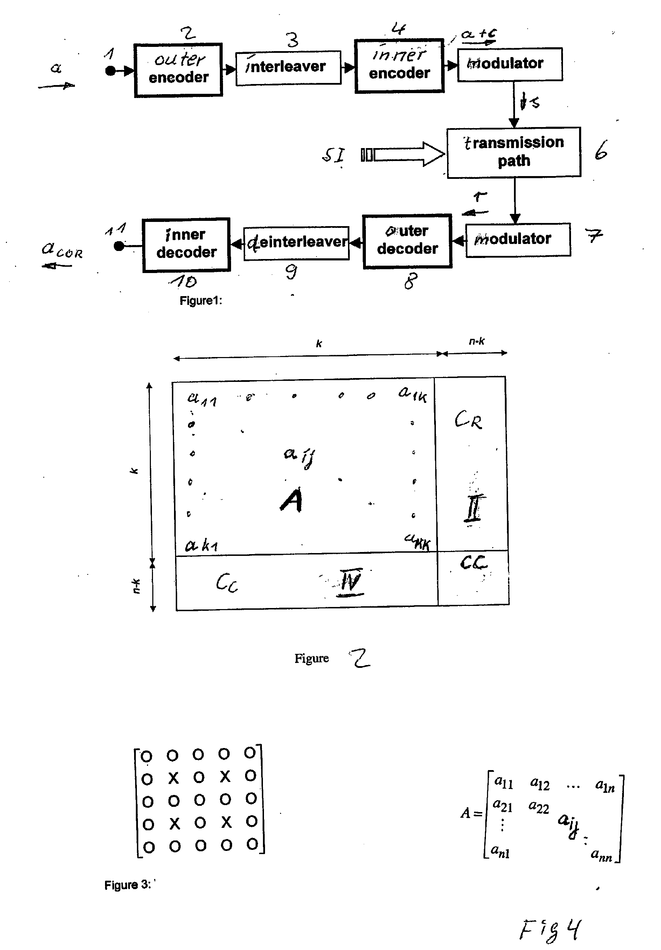

**Figure 1** shows a schematic of a transmission system with a concatenated code implementation. The information bits "a" are fed to the input 1 of an outer encoder 2, which is the first element of a serial concatenation including an interleaver 3 and an inner encoder 4. At least one of the codes is supposed to be a product code, whereas the other code can be a simple code or a concatenated code itself. The information bits "a" and the generated check bits "c" are fed to a modulator 5, which converts the bits into physical signals "s" being transmitted over the transmission path 6 to a demodulator 7 at the receiving side. Because of the non ideal transmission path the signals are disturbed by signal impairments SI, e.g. external perturbations or physical effects of the transmission path. The demodulator 7 converts the received signals into (binary) bits "r", which are fed to a serial concatenation of an inner decoder 8, a deinterleaver (inverse interleaver) 9 and an outer decoder 10. The corrected information bits $a_{COR}$ are emitted at the output 11.

In **figure 2** a code word of a two-dimensional product code is shown, which may be generated by the outer encoder 2. The code word matrix has the dimension of n × n bits and contains k × k information bits, the generated check bits $C_C$ and $C_R$ allow the correction of at least one error for each column or row.

Checks on check-bits CC can be used for checking the check-bits $C_C$ and $C_R$. Of course, also a non square code word matrix and also different codes can be used for rows and columns.

In **figure 3** an example of a permanent 4-error-event for a 2D (two dimensional) product code with one-error-correcting codes as component codes is shown. In case of two errors in one row or column a component one-error-correcting code is overloaded and its decoder will, with high probability, add new errors. In this case the product code will also be overloaded because all the errors occur in exactly two columns and two rows. Hence the errors will never be corrected by the product code alone, no matter how many iterations are used.

The error pattern is permanent and leads to error flaring. For component codes that can correct two or more errors corresponding permanent error patterns exist.

However, such error patterns, which are permanent with regard to the product code alone, may be resolved in the overall concatenation thanks to the interleaver and the inner coding and decoding stages.

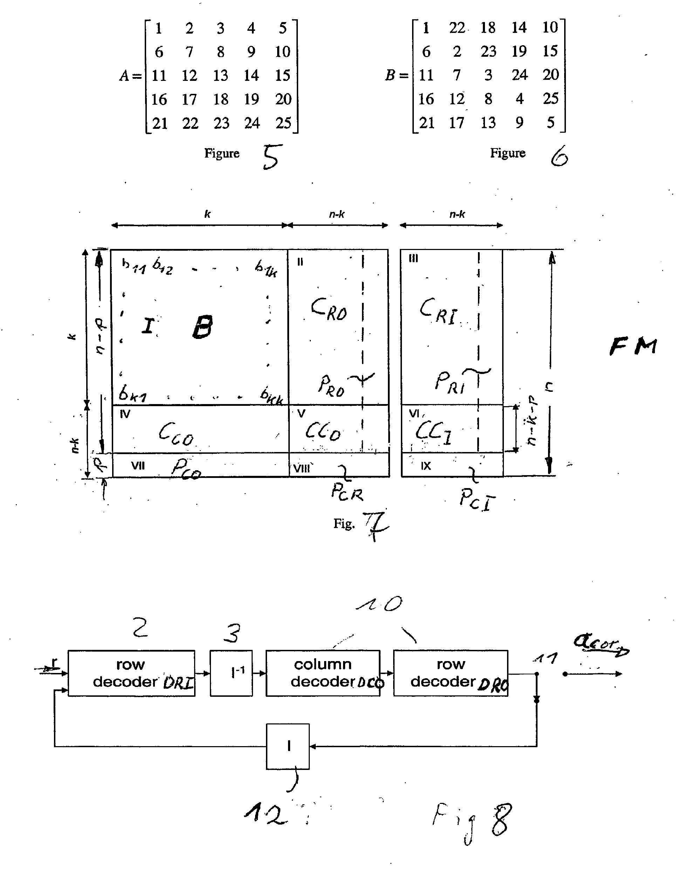

We consider the product code word in the general form of **figure 4**. The elements $a_{11}..a_{ij}..a_{nn}$ form a 2-dimensional code word or code word matrix. The interleaver 3 shown in figure 1 maps the matrix A into a matrix B defined by the equation

$$(1) \qquad b(i,j)=a((n+i-j)\mathrm{mod}\ n+1,j).$$

**Figures 5 and 6** show the original matrix A and the "interleaved" matrix B with exemplary elements, which may help to understand this operation. All binary elements $a_{ij}$ in figures 5 and $b_{ij}$ in figure 6 are represented by natural numbers, representing their original bit sequence. In the interleaving process, regarding matrix A, the elements 1, 6, 11,16, 21 of the first column remain in their positions; the elements 2, 7, 12, 17, 22 of the second column are shifted downwards cyclically by one position; the elements of the third column are cyclically shifted by two positions and so on. Matrix A is translated to matrix B as shown in figure 6. An interleaver performing this procedure can be realised easily.

The corresponding deinterleaver is described by the equation

$$(2) \qquad a(i,j)=b((i+j-2)\mathrm{mod}\,n+1,j).$$

After interleaving an additional inner code is used for encoding matrix B.

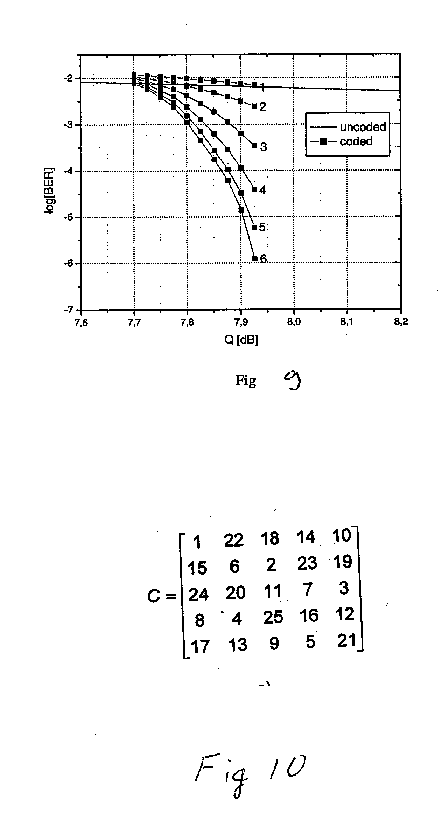

The final code matrix FM is shown in **figure 7**, for the case that the inner code is a simple (non-concatenated) block code. The overall encoding procedure is detailed in the following.

According to figure 2 the information bits $a_{ij}$ organized in the matrix A are fed to the outer encoder 2, which is an encoder for a 2D (two dimensional) product code. The component code for the realization of the outer product code is obtained by extending a base cyclic code. The checks associated with the base code are denoted by C, whereas the additional checks (e.g. parity) of the extended code are denoted by P.

The row check bits $C_{RO}$, separately generated for each row of matrix A by the outer code, are represented in section II, and the column check bits $C_{CO}$ of the columns, separately generated for each column by the outer code, are represented in section IV. Additional parity bits $P_{RO}$, $P_{CO}$ are generated to improve the error detecting capability of the code. The column parity bits $P_{CO}$ are presented in a separate section VII. The row parity bits $P_{RO}$ are embedded in sections II and V.

Checks on check-bits $CC_O$ (inclusive parity bits $P_{RO}$) are generated and positioned in section V. The (column) parity bits $P_{CR}$ of sections II and V are presented in section VIII (because of linearity they are also check bits of section VII).

After the outer encoding, the sections I and IV are interleaved according to equation (1). The "A" matrix (not shown in figure 1) at the input of the interleaver 3 of figur 1 has the dimension (n - p) $\times$ k according to sections I and IV of figure 7. By shifting the columns of section I and IV an "interleaved" code-matrix (B, $C_{CO}$, figure 7) is obtained. The original information matrix A (figure 2) with elements $a_{ij}$ is converted into matrix B with shifted information bits $a_{ij}$, now presented as elements $b_{ij}$ shown of section I. Also the column check bits (with the exception of the last p rows containing additional check bits / parity check bits) are presented in interleaved form $C_{CO}$ in section IV. The interleaver does not alter the remaining sections II, V, VII and VIII .

After interleaving sections I and IV the inner encoder encodes row-wise the elements of sections I and IV. The generated inner code check bits $C_{RI}$ and $CC_I$ are represented in sections III and VI. The additional parity bits of the encoded rows $P_{RI}$ are represented also in sections III and VI. Additional column check (parity) bits $P_{CI}$, derived from sections III and VI, are mapped into section IX. This encoding procedure assures that every bit of the code words except the (n - k) $\times$ p elements of section IX are encoded at least twice.

As extended cyclic codes are used as component codes, the columns in section I and IV represent valid code words of the base code before and after interleaving. After the inner encoding stage the rows of the combined sections I and III and the rows of the combined sections IV and VI represent also valid code words. Hence, due to the linearity, the columns of section III and VI are also valid code words. Because of the linearity of the codes, this coding scheme requires a moderate amount of redundancy.

The described coding scheme is only an example of the present invention. Of course rows and columns of the code matrix can be interchanged and the also the outer and the inner code can be interchanged. The sequence of the transmitted bits should always be considered. If burst errors occur in an example according to figure 7 the either the transmitted bits should be transmitted in the following sequence $b_{11}$, $b_{21}$, ... $b_{k1}$; $b_{12}$, $b_{22}$, ...,$b_{k2}$; .. or instead of the rows the columns should be protected by the inner code.

Several iterative decoding strategies can be devised. An example is shown in **figure 8**. The realised decoding procedure provides a good suppression of error flaring. The decoding device is this serial connection of the "inner row decoder" (RCI) 8, the deinterleaver 9, and an outer decoder 10, which is separated in an "outer column decoder" (DCO) and an "outer row decoder" (DRO).

At the beginning of the decoding process the inner decoder (row decoder I) decodes n-p interleaved rows (sections I and III; IV and VI). The last p rows are not valid code words, and hence are not processed. The inner decoder, row decoder I, operates on the combined rows of sections I and III, and of sections IV and VI of the received final code matrix FM. Thereafter, sections I and IV are deinterleaved (funktion $I^{-1}$). The outer column decoder (first section of the outer decoder 10) decodes all n columns in sections I, IV, and VII, in sections II, V, and VIII, and in sections III, VI, and IX.

The outer row decoder DRO (second section of the outer decoder 10) decodes all n rows, namely the combined rows of sections I and II, IV and V, and VII and VIII. Herewith the first iteration is finished.

After each decoding iteration the corrected elements are transformed into the form of the final code matrix FM by an additional interleaver 12 (function I) and fed to the inner row decoder 2 again. After several iterations the decoding process is stopped.

As an example, an extended BCH code (n = 256, k = 239, d = 6) is used both as component code for the outer product code and as inner code. The basis BCH code (255, 239) is extended by one additional parity bit, hence p = 1 in this case. The simulated bit error rate BER is shown in **figure 9** for consecutive iterations 1 - 6.

For breaking error bursts in rows and in columns a second interleaver respectively a two-dimensional interleaver can be used between inner and outer encoding stages. After shifting cyclically the columns as shown in the example figure 6, all rows are shifted by 0, 1, 2, 3, etc. positions. The resulting matrix C is shown in **Figure 10**. The operation of the row-interleaver can be described by the equation

$$(3) \qquad c(i,j)=b(i,(n+i-j)\bmod n+1),$$

and the function of a deinterleaver is described by the equation

$$(4) \qquad b(i,j)=c(i,(i+j-2)\bmod n+1).$$

The function of the two-dimensional interleaver can be described by equation

$$(5) \qquad c(i,j)=a((n+2i-j-i)\bmod n+1,(n+-i)\bmod n+1)$$

and the function of the two-dimensional deinterleaver can be described by function

$$(6) \qquad a(i,j)=c((i+j-2)\bmod n+1,(i+2j-3)\bmod n+1).$$

$$(7)$$

In the case of a combined two dimensional interleaver n should be an odd an odd number.

**Claims**

1. Method for improving the performance of concatenated codes implying the steps of
generating check bits ($C_R$; $C_C$) from information bits ($a_{11}$,..., $a_{ij}$, ..., $a_{kk}$), which are represented by an information matrix (A), by an outer code,
then interleaving the information bits ($a_{ij}$; i = 1, 2, 3, .., k, j = 1, 2, ..., k) and at least part of the check bits ($C_C$) by shifting the bits cyclically in different columns (j = 1, 2, ..., k) all bits by different values (0, 1, 2, ..., k-1) to obtain an interleaved code matrix (B, $C_{CO}$), and then encoding the bits of the interleaved code matrix (B, $C_{CO}$) by an inner code, where at least the outer code or the inner code is a product code.

2. Method according to claim 1,
wherein the outer code is a product code,
implying the steps of encoding only all columns and rows of information bits ($a_{11}$,..., $a_{ij}$, ..., $a_{kk}$), which are represented in the information matrix (A), by an outer code in order to generate column check bits ($C_C$) and row check bits ($C_R$) of each column and row, then interleaving the information bits ($a_{ij}$) and at least said column or row check bits ($C_C$; $C_R$).

3. Method according to claim 1 or 2,
wherein the bits ($a_{i1}$) of the first column are not shifted and the elements of the following columns (j = 2, 3, ..., k) are cyclically shift by 1, 2, 3, ..., k-1 positions.

4. Method according to claim 1 or 2,
wherein the bits ($a_{ik}$) of the last column are not shifted and the bits of the forgoing columns are cyclically shifted by 1, 2, 3 ...k-1 positions.

5. Method according to one of the foregoing claims,
wherein the bits ($b_{ij}$) of each row are additionally cyclically shifted by different values (e.g. 0, 1, 2, 3, ...) for different rows.

6. Method according to claim 4,
wherein the elements of a first row are not shifted and the elements of the following or forgoing rows are cyclically shifted by 1, 2, 3, ... n-1 positions.

7. Method according to claim 2 or 6,
implying the steps of
encoding the information bits ($a_{ij}$), which are represented in the information matrix (A), in order to generate column check bits ($C_C$), row check bits ($C_R$), and checks on check-bits (CC) by the outer code representing a product code; generating additional column parity bits ($P_{CO}$) for all columns; generating additional row parity bits ($P_{RO}$) for all rows; interleaving the columns of the code matrix (A, $C_C$) containing the information bits ($a_{ij}$) and the column check bits ($C_C$) to obtain an interleaved code matrix (B, $C_{CO}$); encoding the interleaved code matrix (B, $C_{CO}$) by the inner code in order to generate inner row check bits ($C_{RI}$, $CC_I$) of the interleaved information bits (B = $b_{ij}$) and the dependent interleaved column check bits ($C_{CO}$); generating additional inner row parity bits ($P_{Ri}$) of the interleaved code matrix (B, $C_{CO}$) and depending inner row check bits ($C_{RI}$, $CC_I$); and generating inner parity bits ($P_i$) of the inner row check bits ($C_{RI}$, $CC_I$) and inner row parity bits ($P_{Ri}$).

**8.** Method according to claim 1 or 7, where the coding procedures of rows and columns are interchanged.

**10.** Method according to claims 2 - 7, wherein interleaving or deinterleaving of the code bits in columns and rows is performed by means of a two-dimensional interleaver.

**11.** Method according to claim 1 - 10, implying the step of iterative decoding each transmitted final code matrix (FM) wherein the decoding steps are executed inversely to the encoding steps.

Figure1:

Figure 2

Figure 3:

$$A = \begin{bmatrix} a_{11} & a_{12} & \cdots & a_{1n} \\ a_{21} & a_{22} & & \\ \vdots & & a_{ij} & \vdots \\ a_{n1} & & & a_{nn} \end{bmatrix}$$

Fig 4

$$A = \begin{bmatrix} 1 & 2 & 3 & 4 & 5 \\ 6 & 7 & 8 & 9 & 10 \\ 11 & 12 & 13 & 14 & 15 \\ 16 & 17 & 18 & 19 & 20 \\ 21 & 22 & 23 & 24 & 25 \end{bmatrix}$$

Figure 5

$$B = \begin{bmatrix} 1 & 22 & 18 & 14 & 10 \\ 6 & 2 & 23 & 19 & 15 \\ 11 & 7 & 3 & 24 & 20 \\ 16 & 12 & 8 & 4 & 25 \\ 21 & 17 & 13 & 9 & 5 \end{bmatrix}$$

Figure 6

Fig. 7

Fig 8

Fig 9

$$ C = \begin{bmatrix} 1 & 22 & 18 & 14 & 10 \\ 15 & 6 & 2 & 23 & 19 \\ 24 & 20 & 11 & 7 & 3 \\ 8 & 4 & 25 & 16 & 12 \\ 17 & 13 & 9 & 5 & 21 \end{bmatrix} $$

Fig 10

## EUROPEAN SEARCH REPORT

**European Patent Office**

**Application Number**

EP 02 00 9987

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 546 409 A (KARASAWA KATSUMI) 13 August 1996 (1996-08-13) * the whole document * | 1-11 | H03M13/29 H03M13/27 |
| A | EP 0 674 395 A (TOKYO SHIBAURA ELECTRIC CO) 27 September 1995 (1995-09-27) | | |

**TECHNICAL FIELDS SEARCHED (Int.Cl.7)**

H03M

The present search report has been drawn up for all claims

| Place of search | Date of completion of the search | Examiner |
|---|---|---|
| THE HAGUE | 30 September 2002 | Devergranne, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 02 00 9987

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2002

| Patent document cited in search report | | Publication date | Patent family member(s) | | Publication date |
|---|---|---|---|---|---|
| US 5546409 | A | 13-08-1996 | JP | 5029953 A | 05-02-1993 |
| | | | JP | 5029954 A | 05-02-1993 |
| | | | JP | 5055927 A | 05-03-1993 |
| | | | DE | 69223694 D1 | 05-02-1998 |
| | | | DE | 69223694 T2 | 23-04-1998 |
| | | | EP | 0523969 A1 | 20-01-1993 |
| EP 0674395 | A | 27-09-1995 | JP | 7262030 A | 13-10-1995 |
| | | | JP | 7271619 A | 20-10-1995 |
| | | | EP | 0674395 A2 | 27-09-1995 |